# FASCICULE DE BREVET EUROPEEN

(11) **EP 3 629 487 B1**
(45) Date de publication et mention de la délivrance du brevet: **11.11.2020**
(21) Numéro de dépôt: 19197739.6
(22) Date de dépôt: 17.09.2019
(51) Int. Cl.: H04B 5/00, H04W 4/80, H03L 7/085, H03L 7/10, H03L 7/14

(54) **SYNCHRONISATION RAPIDE ENTRE UN OBJET ET UN LECTEUR COMMUNIQUANT SANS CONTACT PAR UNE MODULATION ACTIVE DE CHARGE**
SCHNELLSYNCHRONISIERUNG ZWISCHEN EINEM OBJEKT UND EINEM LESEGERÄT, DIE KONTAKTLOS ÜBER EINE AKTIVE MODULATION DER LADUNG KOMMUNIZIEREN
QUICK SYNCHRONISATION BETWEEN AN OBJECT AND A CONTACTLESS READER COMMUNICATING BY ACTIVE LOAD MODULATION

(30) Priorité: 25.09.2018 FR 1858732
(43) Date de publication de la demande: 01.04.2020
(73) Titulaire: STMICROELECTRONICS SA, 92120 Montrouge (FR)
(72) Inventeur: HOUDEBINE, Marc, 38920 CROLLES (FR)
(74) Mandataire: Casalonga

(56) Documents cités:
- EP-A1- 2 763 076
- EP-A1- 3 276 986
- US-A1- 2008 100 386
- US-A1- 2010 039 183

## Description

Des modes de mise en œuvre et de réalisation de l'invention concernent la communication sans fil ou sans contact utilisant des dispositifs sans contact ou composants électroniques connectés à une antenne, notamment des dispositifs configurés pour échanger des informations avec un lecteur via ladite antenne selon un protocole de communication du type sans contact.

La publication de la demande de brevet EP3276986 A1 divulgue un procédé de communication sans contact entre un objet et un lecteur utilisant une modulation active de charge, le procédé assure une synchronisation entre un signal de porteuse émis par le lecteur et ayant une fréquence de référence, et un autre signal de porteuse délivré par la sortie d'un oscillateur commandé d'une boucle à verrouillage de phase dudit objet.

Des modes de mise en œuvre et de réalisation de l'invention concernent plus particulièrement la communication sans contact entre un dispositif sans contact et un lecteur à une fréquence de 13.56 MHz en utilisant une modulation active de charge (ALM : « Active Load Modulation » pour la communication avec le lecteur et plus particulièrement la synchronisation entre un signal de porteuse lecteur et un signal de porteuse généré au sein du dispositif (signal d'horloge de porteuse ALM).

Ces composants ou dispositifs sans contact peuvent être par exemple des composants ou dispositifs dits « NFC » c'est-à-dire des dispositifs compatibles avec la technologie NFC (« Near Field Communication »).

Le dispositif NFC peut être par exemple un circuit intégré ou une puce incorporant un microcontrôleur NFC.

L'acronyme NFC désigne une technologie de communication sans fil haute fréquence faible distance, qui permet des échanges de données entre deux dispositifs sans contact sur une faible distance par exemple 10 cm.

La technologie NFC est une plateforme technologique ouverte normalisée dans la norme ISO/IEC 18092 et ISO/IEC 21481 mais incorpore de nombreuses normes déjà existantes comme par exemple les protocoles type A et type B définis dans la norme ISO-14443 qui peuvent être des protocoles de communication utilisables dans la technologie NFC.

Outre sa fonction classique de téléphone, un téléphone mobile cellulaire peut être utilisé (s'il est équipé de moyens spécifiques) pour échanger des informations avec un autre dispositif sans contact, par exemple un lecteur sans contact, en utilisant un protocole de communication sans contact utilisable dans la technologie NFC.

On peut également citer d'autres dispositifs sans contact comme une montre connectée.

Ceci permet d'échanger des informations entre le lecteur sans contact et des éléments sécurisés situés dans le téléphone mobile. De nombreuses applications sont ainsi possibles comme la billetterie mobile dans les transports publics (le téléphone mobile se comporte comme un ticket de transport) ou bien le paiement mobile (le téléphone mobile se comporte comme une carte de paiement).

Lors d'une transmission d'information entre un lecteur et un objet émulé en mode étiquette ou carte, le lecteur génère un champ magnétique par l'intermédiaire de son antenne qui est généralement dans les normes classiquement utilisées, une onde sinusoïdale à 13.56 MHz. La force du champ magnétique est comprise entre 0.5 et 7.5 ampères/mètre RMS (« Root Mean Square » en anglais).

Deux modes de fonctionnement sont alors possibles, un mode passif ou un mode actif.

Dans le mode passif, seul le lecteur génère le champ magnétique et l'objet, émulé en mode étiquette ou carte, est alors passif et joue toujours le rôle de la cible.

Plus précisément, l'antenne de l'objet émulant l'étiquette ou la carte module le champ généré par le lecteur.

Cette modulation est effectuée en modifiant la charge connectée aux bornes de l'antenne de l'objet.

En modifiant la charge aux bornes de l'antenne de l'objet, l'impédance de sortie de l'antenne du lecteur change en raison du couplage magnétique entre les deux antennes. Il en résulte un changement dans les amplitudes et/ou les phases des tensions et courants présents au niveau des antennes du lecteur et de l'objet.

Et, de cette façon, les informations à transmettre depuis l'objet vers le lecteur sont transmises par modulation de charge aux courants d'antenne du lecteur.

La variation de charge effectuée lors de la modulation de charge se traduit par une modulation d'amplitude et/ou de phase du signal (tension ou courant) au niveau de l'antenne du lecteur. Une copie du courant d'antenne est générée et injectée dans la chaîne de réception du lecteur où ce courant est démodulé et traité de façon à extraire les informations transmises.

Dans le mode de fonctionnement actif, le lecteur et l'objet émulé en mode carte génèrent tous les deux un champ électromagnétique. Généralement, ce mode de fonctionnement est utilisé lorsque l'objet est pourvu d'une source d'alimentation propre, par exemple une batterie, comme c'est le cas dans un téléphone mobile cellulaire qui est alors émulé en mode carte.

Chacun des dispositifs NFC transmet les données en utilisant un schéma de modulation.

Là encore, la modulation se traduit par une modification de charge et l'on parle alors d'une communication par modulation active de charge.

Par rapport à un mode de communication passif, on obtient des distances de fonctionnement plus importantes qui peuvent aller jusqu'à 20 cm en fonction du protocole utilisé.

Par ailleurs, l'utilisation d'une modulation active de charge permet d'utiliser des antennes très petites.

Cela étant, ce type de communication par modulation active de charge pose d'autres problèmes.

En effet, durant les périodes de communication active du dispositif émulé en mode carte, le champ électromagnétique du lecteur n'est pas directement observable. Et ceci peut conduire à une réponse de l'objet émulé en mode carte non synchrone et par conséquent à un signal reçu par le lecteur présentant un décalage de phase, en particulier lors de longues périodes d'émission par le dispositif émulé en mode carte

Ceci est d'autant plus observable lorsque le dispositif émulé en mode carte réalise une modulation numérique de type BPSK (Binary phase-shift Keying » en anglais) et transmet des informations au lecteur en utilisant le protocole de communication de type B à une vitesse de 848 Kbits/s.

De plus, pour qu'une boucle à verrouillage de phase soit stable, il est recommandé d'utiliser une fréquence fixe. Pour ce faire, on restitue au mieux quelques pulsations du signal reçu sur une série de pulsations. Le signal reçu peut donc avoir une fréquence jusqu'à 32 fois plus faible limitant ainsi la bande passante de la boucle à verrouillage de phase. Cette limitation conduit à des instabilités au niveau du système.

Egalement, lorsque dispositif émulé en mode carte réalise un codage Manchester pour transmettre des informations au lecteur et utilise le protocole de communication de type A à une vitesse de 106 Kbits/s, cela conduit à un décalage de phase.

Si l'on considère deux dispositifs indépendants, à savoir le lecteur et un objet émulé en mode carte, capables de communiquer sans contact par une modulation active de charge, il existe par conséquent un besoin pour réduire au maximum voire supprimer ce décalage de phase.

Selon un aspect, il est proposé un procédé de communication sans contact entre un objet et un lecteur utilisant une modulation active de charge, le procédé comprend une synchronisation entre un premier signal de porteuse émis par le lecteur et ayant une fréquence de référence par exemple 13.56 MHz, et un deuxième signal de porteuse tiré du signal de sortie d'un oscillateur commandé d'une boucle à verrouillage de phase numérique dudit objet, ladite synchronisation comprend :
- tant qu'un verrouillage de ladite boucle n'a pas été détecté, un asservissement de la fréquence du signal de sortie de l'oscillateur sur une fréquence multiple de la fréquence de référence, en commandant l'oscillateur avec un premier signal de commande généré à partir d'une première valeur représentative de l'erreur de phase de ladite boucle à verrouillage de phase, et
- une fois ledit verrouillage détecté, une poursuite de l'asservissement en commandant l'oscillateur avec un deuxième signal de commande généré à partir d'une deuxième valeur obtenue par une opération du type modulo effectuée sur ladite première valeur représentative de l'erreur de phase de la boucle.

L'asservissement peut être un asservissement en fréquence ou bien un asservissement en fréquence et en phase.

On notera ici qu'une fréquence multiple de la fréquence de référence s'entend au sens large, c'est-à-dire que ladite fréquence multiple est égale à k fois la fréquence de référence avec k supérieur ou égal à 1.

Par ailleurs on peut considérer par exemple que le verrouillage de la boucle est détecté si l'erreur de phase est inférieure en valeur absolue à un seuil.

L'homme du métier saura choisir la valeur de ce seuil en fonction de l'application et/ou des caractéristiques de la boucle.

Cela étant à titre d'exemple non limitatif, on pourra prendre un seuil égal à environ 30 degrés à 13.56 MHz.

Par « premier signal de porteuse » on entend par exemple un signal d'horloge qui sera généré et injecté dans la chaîne de réception et de transmission de l'objet émulé en mode carte.

Par « deuxième signal de porteuse » on entend par exemple un signal d'horloge qui sera généré et injecté dans la chaîne de réception et de transmission du lecteur. Ledit deuxième signal a également la même fréquence de référence pour réaliser une communication synchrone.

L'oscillateur est commandé par un premier signal de commande, typiquement un mot numérique de commande, dans le but de générer ledit deuxième signal de porteuse dont la fréquence est proportionnelle audit premier signal de commande appliqué à son entrée. Or, ledit premier signal de commande, lors de l'apparition des problèmes décrits ci-dessus, impacté par ladite première valeur représentative de l'erreur de phase, rend difficile voire impossible la convergence de la boucle à verrouillage de phase, conduisant à des instabilités. C'est pourquoi, l'oscillateur est avantageusement commandé par ledit deuxième signal de commande généré par ladite deuxième valeur représentative de l'erreur.

Ladite deuxième valeur représentative de l'erreur est bien inférieure à ladite première valeur grâce à l'opération de type modulo sur ladite première valeur. Cela permet de faire converger la boucle à verrouillage de phase rapidement et réduit les dérives de phase.

La deuxième valeur représentative de l'erreur ne peut être générée qu'après verrouillage de la boucle à verrouillage de phase. En effet, l'opération de type modulo peut conduire à des sauts de phase avant ledit verrouillage. C'est pour cela que l'opération de type modulo n'est avantageusement activée qu'après la détection dudit verrouillage.

Comme indiqué ci-avant, l'oscillateur peut délivrer un signal ayant une fréquence égale à k fois (avec k strictement supérieur à 1) la fréquence de référence, par exemple une fréquence de 867.84 MHz ou bien ladite fréquence de référence elle-même. Dans le cas où k est strictement supérieur à 1, cette fréquence sera ensuite divisée de telle sorte à obtenir ladite fréquence de référence et ainsi permettre la synchronisation entre le lecteur et l'objet émulé en mode carte.

Bien entendu si le signal a ladite fréquence de référence (k=1) ladite fréquence ne sera pas divisée.

Il est également à noter que la boucle à verrouillage de phase est numérique permettant avantageusement une stabilisation de la boucle, même avec une marge de phase élevée, par exemple supérieure à 50°.

Selon un mode de mise en œuvre, ladite première valeur est un mot numérique comprenant une première séquence de bits, et ladite opération du type modulo comprend une sélection de bits de poids faible représentant une deuxième séquence de bits représentative de ladite deuxième valeur.

L'opération de type modulo permet de réduire considérablement ladite première valeur représentative de l'erreur de phase de la boucle conduisant ainsi à une deuxième valeur. Par exemple, si la première valeur est 67, la boucle à verrouillage de phase cherchera à réduire ladite erreur et cela peut prendre du temps avant de réussir à faire converger la boucle vers 0. L'opération de type modulo dans ce cas comprend par exemple la sélection des bits de poids faible, par exemple « 0000011 » correspondant à 3, de la première séquence qui est de « 1000011 » correspondant à 67. L'erreur vaut donc 3.

Cette opération est répétée pour faire tendre l'erreur de phase vers 0 et ainsi faire converger la boucle à verrouillage de phase rapidement.

Selon un mode de mise en œuvre, le procédé comprend préalablement à l'asservissement par ladite boucle, un masquage et/ou une multiplication de la fréquence du premier signal de porteuse par un masque et/ou un facteur multiplicatif.

Un masquage de la fréquence d'un signal numérique s'entend comme un masquage de certaines périodes du signal et peut donc s'apparenter à une division de la fréquence.

La stabilité de la boucle à verrouillage de phase est indépendante de la fréquence du premier signal de porteuse grâce à l'opération de type modulo. On peut donc multiplier la fréquence du premier signal de porteuse par un facteur multiplicatif pour permettre au dispositif émulé en mode carte d'opérer sur le front montant et le front descendant du premier signal de porteuse.

En fonction des besoins du système et de ses composants par exemple l'antenne et son coefficient de qualité, la fréquence du premier signal de porteuse peut être masquée par un masque.

Il est à noter qu'on peut effectuer une seule des deux opérations ou bien les réaliser consécutivement.

Selon un mode de mise en œuvre, le masque ou le facteur multiplicatif est ajustable.

Le masque ou le facteur multiplicatif peut être choisi par une machine à état en fonction de différents paramètres par exemple le facteur de qualité de l'antenne.

On peut également choisir d'avoir un facteur multiplicatif fixe..

Selon un autre aspect, il est proposé un objet capable de communiquer sans contact avec un lecteur par une modulation active de charge, comportant une entrée pour recevoir un premier signal de porteuse émis par le lecteur, une sortie pour délivrer un deuxième signal de porteuse tiré d'un signal de sortie d'un oscillateur commandé d'une boucle à verrouillage de phase numérique, et des moyens de synchronisation configurés pour synchroniser ledit premier signal de porteuse et le deuxième de porteuse, lesdits moyens de synchronisation comprennent :
- des moyens de détection configurés pour détecter le verrouillage de ladite boucle ;
- des moyens de commande configurés pour,
tant que les moyens de détection n'ont pas détecté le verrouillage de ladite boucle, asservir la fréquence du signal de sortie de l'oscillateur sur une fréquence multiple de la fréquence de référence, en commandant l'oscillateur avec un premier signal de commande généré à partir d'une première valeur représentative de l'erreur de phase de ladite boucle à verrouillage de phase, et
une fois que les moyens de détection ont détecté ledit verrouillage, poursuivre l'asservissement en commandant l'oscillateur avec un deuxième signal de commande généré à partir d'une deuxième valeur délivrée par un premier module configuré pour effectuer une opération du type modulo sur ladite première valeur représentative de l'erreur de phase de la boucle.

Selon un mode de réalisation, la première valeur est un mot numérique comprenant une première séquence de bits, et dans lequel ledit premier module est configuré pour effectuer ladite opération en sélectionnant des bits de poids faible représentant une deuxième séquence de bits représentative de ladite deuxième valeur.

Selon un mode de réalisation, les moyens de synchronisation comprennent un deuxième module configuré pour masquer la fréquence du premier signal de porteuse par un masque préalablement à l'asservissement par ladite boucle, et un troisième module configuré pour multiplier la fréquence du premier signal de porteuse par un facteur multiplicatif préalablement à l'asservissement par ladite boucle.

Le troisième module peut être de structure classique ou bien peut comprendre par exemple un doubleur de fréquence décrit dans la demande de brevet français déposée sous le n°1752114.

Selon un mode de réalisation, le facteur de division ou le facteur multiplicatif est ajustable.

Selon un mode de réalisation, la boucle à verrouillage de phase comprend un filtre de type proportionnel intégral configuré pour filtrer ladite première valeur représentative de l'erreur de phase et ladite deuxième valeur représentative de l'erreur de phase.

L'objet peut être par exemple un téléphone mobile cellulaire émulé en mode carte.

D'autres avantages et caractéristiques de l'invention apparaîtront à la lecture de la description détaillée de modes de mise en œuvre et de réalisation, nullement limitatifs, et des dessins annexés sur lesquels :

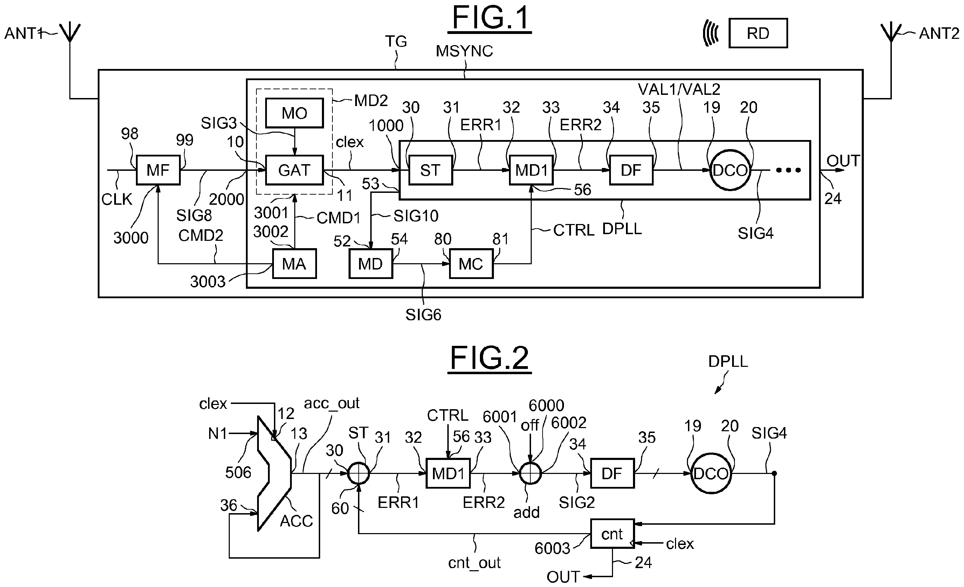

Les figures 1 à 3, 4A, 4B, 4C, 5 et 6 illustrent schématiquement différents modes de mise en œuvre et de réalisation de l'invention.

Sur la figure 1, la référence TG désigne un objet, par exemple un téléphone mobile cellulaire comportant une antenne ANT1 pour les communications téléphoniques. Ledit objet est ici émulé en mode carte et peut par exemple communiquer avec un lecteur RD via une autre antenne ANT2, par exemple une bobine inductrice, par une modulation active de charge, appelée MAC (ALM en anglais pour « Active Load Modulation »).

Pour communiquer avec le lecteur RD, ledit objet TAG comprend des moyens de synchronisation MSYNC configurés pour recevoir par une borne d'entrée 2000 après traitement, un premier signal de porteuse CLK ayant une fréquence de 13.56 MHz. Cette fréquence est une fréquence de référence sur laquelle l'objet TG vise à se synchroniser en utilisant lesdits moyens de synchronisation MSYNC, lors de la communication dudit objet vers le lecteur RD.

Ledit objet TG comprend un premier module MD1 configuré pour effectuer une opération modulo, un deuxième module MD2 configuré pour masquer la fréquence d'un signal par un masque, et un troisième module MF, ici un multiplicateur de fréquence configuré pour multiplier la fréquence d'un signal par un facteur.

Le multiplicateur de fréquence MF est configuré pour recevoir par sa borne d'entrée 98 le premier signal de porteuse CLK et pour délivrer par sa borne de sortie 99, ledit premier signal de porteuse CLK dont la fréquence a été multipliée par un facteur, ici SIG8. Ce signal SIG8 est ensuite délivré aux moyens de synchronisation MSYNC par ladite borne d'entrée 2000.

Lesdits moyens de synchronisation MSYNC comprennent ledit deuxième module MD2 configuré pour masquer par un masque la fréquence dudit signal SIG8.

Le deuxième module MD2 est commandé par une machine à état MA configurée pour, en fonction de différents paramètres, par exemple le coefficient de l'antenne ANT2, délivrer un premier signal de commande CMD1 par sa borne de sortie 3002 audit deuxième module MD2 par sa borne d'entrée 3001.

Ladite machine à état MA est également configurée pour délivrer un deuxième signal de commande CMD2 par sa borne de sortie 3003 à une borne d'entrée 3000 du multiplicateur de fréquence MF.

Une alternative consiste à continuellement multiplier ladite fréquence par un facteur multiplicatif fixe. Dans ce cas, ladite machine à état MA n'est plus couplée au multiplicateur de fréquence MF.

Ledit deuxième module MD2 comprend un registre MO configuré pour stocker une valeur SIG3 définie par le signal de commande CMD1 de la machine à état MA. Ledit deuxième module MD2 comprend également un deuxième module GAT configuré pour recevoir par sa borne d'entrée 10 le signal SIG8, le masquer pour délivrer par sa borne de sortie 11, le signal clex.

Les moyens de synchronisation MSYNC comprennent une boucle à verrouillage de phase numérique DPLL comportant un oscillateur DCO commandé par un signal numérique (mot numérique) et configurée pour recevoir par son entrée 1000 ledit signal clex et pour délivrer sur la sortie 20 de l'oscillateur DCO un signal SIG4 ayant une fréquence multiple de la fréquence de référence, par exemple 64x13.56 MHz.

Ledit signal SIG4 est ensuite traité pour obtenir un deuxième signal de porteuse OUT ayant ladite fréquence de référence par une sortie 24.

Pour ce faire, ladite boucle à verrouillage de phase DPLL comprend un additionneur-soustracteur ST configuré pour recevoir ledit signal clex par sa borne d'entrée 30 et pour délivrer le signal ERR1 par sa borne de sortie 31. Le signal ERR1 est un signal numérique représentatif d'une première valeur de l'erreur de phase de la boucle à verrouillage de phase.

Ladite boucle à verrouillage de phase DPLL comprend également ledit premier module MD1 configuré pour recevoir sur sa borne d'entrée 32, le signal ERR1 et pour délivrer par sa borne de sortie 33 le signal ERR2. Ledit premier module MD1 est configuré pour effectuer une opération de type modulo sur le signal ERR1. Le résultat de ladite opération est le signal ERR2 représentatif d'une deuxième valeur de l'erreur de phase de la boucle.

Ledit signal ERR2 est ensuite envoyé à une borne d'entrée 34 d'un filtre numérique DF de ladite boucle à verrouillage de phase DPLL, configuré pour délivrer un premier signal de commande VAL1 ou un deuxième signal de commande VAL2 à l'entrée 19 de l'oscillateur DCO.

Avantageusement, ledit filtre numérique DF peut être de type proportionnel-intégral, ce qui permet de maintenir la stabilité de la boucle DPLL grâce à un choix approprié des pôles dudit filtre.

Bien sûr, l'homme du métier peut utiliser tout filtre numérique ayant les mêmes caractéristiques. Les moyens de synchronisation MSYNC comprennent également des moyens de détection MD configurés pour détecter le verrouillage de la boucle DPLL.

Par « verrouillage », on entend le temps nécessaire à la boucle à verrouillage de phase pour accrocher et se stabiliser. Durant cette phase, certains composants de la boucle que l'on présentera dans la figure 2 sont saturés.

Pour détecter ledit verrouillage, la boucle à verrouillage de phase DPLL est configurée pour délivrer un signal SIG10 représentatif de l'erreur de phase de la boucle, par sa borne de sortie 53, à la borne d'entrée 52 des moyens de détection MD.

Lesdits moyens de détection MD sont configurés pour comparer ledit signal SIG10 à un seuil et délivrer un signal SIG6 à l'état haut si l'erreur de phase est inférieure en valeur absolue audit seuil.

En d'autres termes, le verrouillage de la boucle est détecté si le signal SIG6 est à l'état haut.

Lesdits moyens de détection MD sont configurés pour délivrer ledit signal SIG6 par une borne de sortie 54 à des moyens de contrôle MC par une borne d'entrée 80.

Lesdits moyens de contrôle MC sont configurés pour délivrer un signal de commande CTRL par une borne de sortie 81 à une borne d'entrée 56 du premier module MD1. Ledit signal de commande CTRL est configuré pour, selon son état, désactiver le premier module MD1 tant que la boucle n'a pas été verrouillée ou l'activer après verrouillage de la boucle DPLL pour qu'il effectue une opération modulo.

Une autre alternative serait un premier état permettant d'effectuer une opération modulo par exemple 8x64 lors de la phase de verrouillage de la boucle DPLL pour ne pas altérer son fonctionnement et un deuxième état permettant d'effectuer une opération modulo 64 après verrouillage de ladite boucle.

Si ledit premier module MD1 n'est pas activé, il n'effectuera pas d'opération modulo et le signal ERR1 sera le même que le signal ERR2. En d'autres termes, la borne de sortie 33 du premier module MD1 délivrera le signal ERR1. Dans ce cas, le filtre numérique DF est configuré pour délivrer ledit premier signal de commande VAL1.

Si ledit premier module MD1 est activé, il effectuera ladite opération modulo et le filtre numérique DF délivrera par ladite sortie 35 le deuxième signal de commande VAL2.

La figure 2 représente une vue détaillée de la boucle à verrouillage de phase DPLL.

La boucle à verrouillage de phase DPLL comprend un accumulateur ACC configuré pour être cadencé par ledit premier signal de porteuse clex via une première borne d'entrée 12, et également configuré pour recevoir par une deuxième borne d'entrée 506 une valeur numérique N1 ici 64, et par une troisième borne d'entrée 36, un signal acc_out délivré par ledit accumulateur ACC par la borne de sortie 13.

Ledit signal acc_out est délivré à l'additionneur-soustracteur ST par sa borne d'entrée 30 qui délivrera par sa borne de sortie 31 le signal ERR1. Ledit signal ERR1 est reçu par la borne d'entrée 32 du premier module MD1 qui est configuré pour délivrer le signal ERR2 et à être commandé par le signal CTRL délivré par les moyens de commande MD.

Ledit signal ERR2 est envoyé à un additionneur add par sa première borne d'entrée 6001. Ledit additionneur add est également configuré pour recevoir par sa deuxième borne d'entrée 6000, le signal off représentatif d'une erreur de phase statique afin de de compenser les erreurs de phase du circuit d'adaptation jusqu'à l'antenne.

Ledit additionneur add est configuré pour délivrer par sa borne de sortie 6002, le signal SIG2 représentant le résultat de l'addition entre le signal ERR1 et le signal off.

Ledit filtre numérique DF est configuré pour recevoir par sa borne d'entrée 34 ledit signal SIG2 et pour délivrer par sa borne de sortie 35 ledit premier signal de commande VAL1 ou le deuxième signal de commande VAL2 à la borne d'entrée 19 de l'oscillateur DCO selon le mode de fonctionnement du premier module MD1.

Ledit oscillateur DCO est configuré pour délivrer par sa borne de sortie 20 ledit signal SIG4 qui sera envoyé à un compteur-diviseur cnt (ici un diviseur par 64) configuré pour délivrer par la borne de sortie 24 le deuxième signal de porteuse OUT et pour délivrer un signal cnt_out représentatif du résultat numérique de comptage par sa borne de sortie 6003 à une borne d'entrée 60 de l'additionneur-soustracteur ST.

Le circuit qui vient d'être décrit est ici avantageusement numérique car il permet à la boucle à verrouillage de phase d'avoir une marge de phase supérieure à 50°, ce qui permet de stabiliser la boucle.

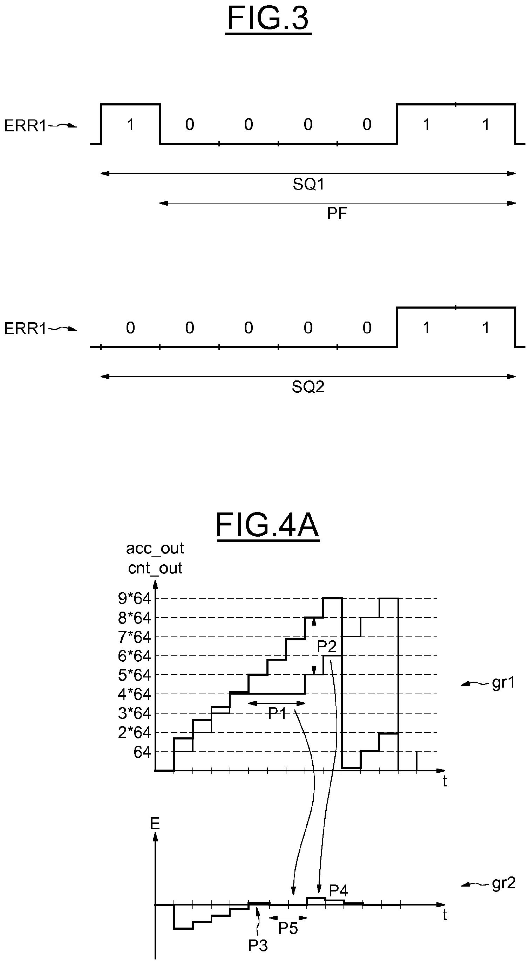

La figure 3 illustre schématiquement ladite opération modulo effectuée par le premier module MD1 une fois activé.

Le signal ERR1 représentatif de l'erreur de phase de la boucle DPLL est un signal ici composé de 7 bits représentant une première séquence SQ1 non signée.

On suppose que le signal ERR1 a une valeur de 67 ce qui équivaut à une séquence SQ1 de « 1000011 ». L'opération modulo consiste à sélectionner les bits de poids faible PF de ladite première séquence ici « 000011 » pour former une deuxième séquence SQ2 de 7 bits, ici « 0000011 » représentant la valeur numérique 3.

Ladite valeur numérique 3 est ici le signal ERR2 représentatif de l'erreur de phase de la boucle à verrouillage de phase DPLL.

L'opération modulo permet donc de diminuer fortement ladite erreur ERR1 et par conséquent, le signal de commande qui sera délivré à l'oscillateur DCO conduira à une légère correction permettant à ladite boucle de converger plus rapidement.

La figure 4A illustre schématiquement un mode de mise en œuvre de l'invention.

Un premier graphe gr1 représente l'évolution temporelle du signal acc_out délivré par l'accumulateur ACC et du signal cnt_out délivré par le compteur-diviseur cnt.

Le deuxième graphe gr2 représente l'évolution temporelle de l'erreur de phase E égale à la différence entre le signal acc_cnt et le signal cnt_out. On peut remarquer que l'erreur E diminue au fur et à mesure et tend vers 0 en P3 par l'action de la boucle à verrouillage de phase DPLL.

La période P1 correspond à une période d'absence du premier signal de porteuse CLK. L'accumulateur ACC étant cadencé par le signal clex extrait du permier signal de porteuse CLK, est figé et donc le signal acc_out n'évolue pas durant la période P1.

Le signal cnt_out est cadencé par l'oscillateur DCO et donc continue de s'incrémenter. Or, l'erreur de phase E ne peut être calculée car l'additionneur-soustracteur ST est également cadencé par le signal clex. Ceci est représenté par la période P5 du deuxième graphe gr2 où on voit que l'erreur E ne varie plus pendant toute la période P1 représentative de l'absence du premier signal de porteuse CLK.

Une fois le premier signal de porteuse de nouveau présent, on peut voir que malgré la grande différence entre les signaux acc_out et cnt_out représentée par P2, l'erreur E n'est pas significative (P4) et tend vers 0. Cela est dû à l'opération modulo ici modulo 64 qui a permis de réduire significativement l'erreur E et d'assurer une bonne poursuite de phase.

On peut également voir que suite à la saturation du compteur-diviseur cnt, l'erreur E tend aussi vers 0. La boucle à verrouillage de phase converge donc plus rapidement et permet donc d'assurer une bonne poursuite de phase.

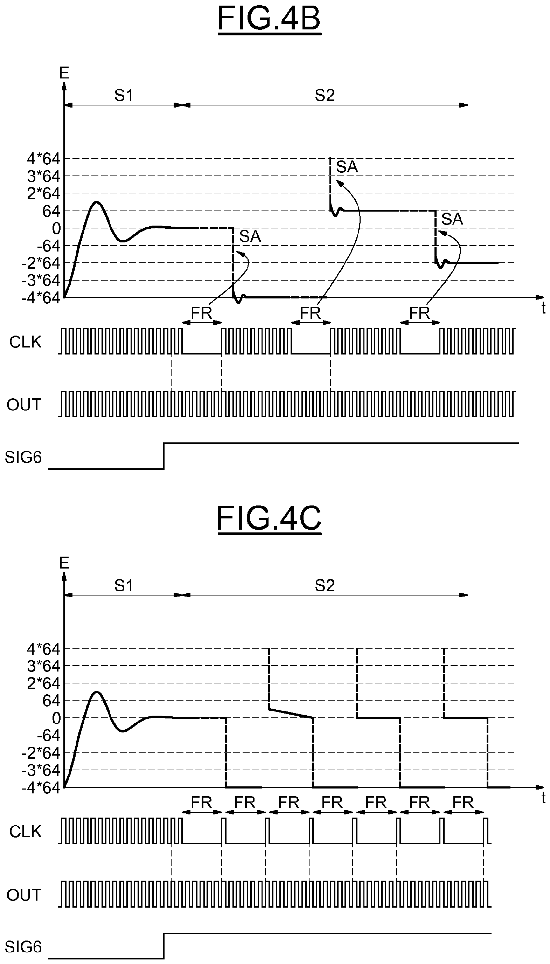

La figure 4B représente l'évolution temporelle du comportement de la boucle à verrouillage de phase DPLL selon un mode de mise en œuvre de l'invention.

Une première période S1 représentative de la phase de verrouillage de la boucle à verrouillage de phase DPLL se déroule durant la présence du premier signal de porteuse CLK.

Une fois la boucle verrouillée, ledit signal SIG6 initialement à l'état bas passe à l'état haut.

Or, ledit premier signal de porteuse CLK est ensuite absent durant des périodes FR, ce qui conduit après retour du premier signal de porteuse CLK à un saut SA de l'erreur de phase E de la boucle à verrouillage de phase dû au décalage entre cnt_out et acc_out. Grâce à l'action du modulo, on remarque qu'à chaque retour du premier signal de porteuse CLK, la boucle à verrouillage de phase DPLL converge rapidement évitant ainsi des dérives de phase.

La convergence rapide de la boucle à verrouillage de phase DPLL permet d'aligner les fronts montant du premier signal de porteuse CLK avec le deuxième signal de porteuse OUT et par conséquent, les deux signaux sont synchronisés.

La figure 4C représente l'évolution temporelle du comportement de ladite boucle DPLL selon un mode de mise en œuvre de l'invention et plus précisément dans le cas de salves rapprochées de réponses de l'objet TAG au lecteur RD.

Dans ce cas, l'énergie résiduelle dans l'antenne ANT2 après chaque salve d'émission limite la durée des périodes FR. Le premier signal de porteuse CLK est alors utilisable moins longtemps et par conséquent le signal clex a une fréquence plus faible. Sans l'action du modulo, cela conduit à des dérives de phase.

L'action du modulo permet ici après verrouillage (période S1) de ladite boucle DPLL de faire converger la boucle rapidement durant la période S2 et aligner les fronts montants du premier signal de porteuse CLK et du deuxième signal de porteuse OUT. Par conséquent, quelle que soit la fréquence d'échantillonnage du premier signal de porteuse CLK, les fronts montant du premier signal de porteuse CLK et du deuxième signal de porteuse OUT s'alignent.

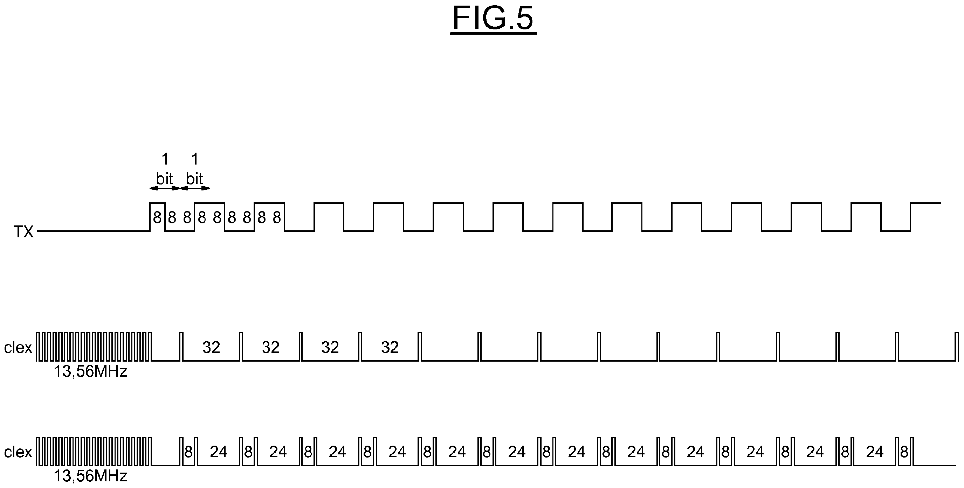

La figure 5 représente l'action du deuxième module MD2 sur le signal clex.

Lors d'une émission de données TX, les données sont codées, ici par le codage BPSK pour une transmission par le protocole de type B à une vitesse de 848 kbps et dans le cas d'une inversion de bits à chaque transmission. Le codage conduit à un premier signal de porteuse CLK comprenant entre chaque pulsation, 32 périodes de 13.56 MHz.

Sans l'action du modulo et du filtre DF qui permet de ne plus prendre en considération les périodes d'absence du premier signal de porteuse CLK, la boucle à verrouillage de phase DPLL ne peut plus être synchrone avec la phase du lecteur RD au coup par coup. Cela conduit à un signal ayant une fréquence plus faible limitant ainsi la bande passante de la boucle à verrouillage de phase DPLL, ce qui conduit à des instabilités.

Pour maintenir une bande passante la plus large possible dans le but d'optimiser les réjections de bruits des différents modules et la variation de la fréquence de la boucle à verrouillage de phase DPLL, la correction de l'erreur de phase est avantageusement faite le plus possible.

Pour ce faire, il est avantageux de restituer les périodes stables du signal CLK extrait du champ électromagnétique du lecteur le plus possible même si le signal CLK n'est pas périodique. Ainsi à cet égard, le registre MO en envoyant ledit signal SIG3 au deuxième module GAT permet de masquer le premier signal de porteuse CLK non pas toutes les 32 périodes mais par une valeur optimum choisie par exemple 24, 8 ou toute autre valeur, ce qui permet d'élargir la bande passante de la boucle à verrouillage de phase DPLL.

Le facteur de division est choisi par ladite machine à état MA en fonction de plusieurs paramètres, par exemple le facteur de qualité de l'antenne ANT2.

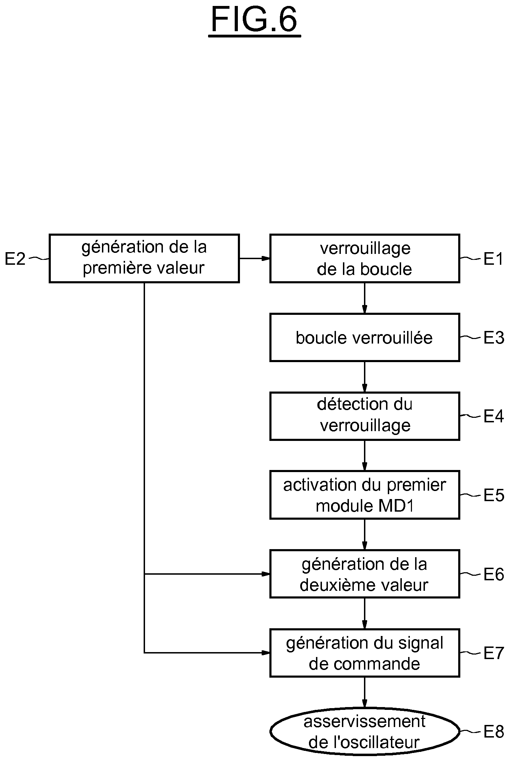

La figure 6 illustre un diagramme de flux représentatif d'un mode de mise en œuvre de l'invention.

Les étapes E1 à E4 correspondent à la période pendant laquelle la boucle à verrouillage de phase DPLL essaie de se verrouiller. Pour cela, l'additionneur-soustracteur ST élabore, dans l'étape E2 ledit signal ERR1 représentatif de la première valeur de l'erreur de phase de la boucle DPLL, ce qui conduit à la génération du premier signal de commande VAL1 dans l'étape E7.

Ledit premier signal de commande VAL1 est ensuite délivré à l'oscillateur DCO afin de l'asservir en fréquence dans l'étape E8.

Une fois la boucle verrouillée (étape E3), les moyens de détection MD détectent ledit verrouillage par la réception du signal SIG10 et délivrent le signal SIG6 à l'état haut aux moyens de contrôle MC configurés pour activer ledit premier module MD1 dans l'étape E5.

L'additionneur-soustracteur ST continue de délivrer le signal ERR1 sur lequel sera effectuée l'opération modulo par le premier module MD1 délivrant ainsi le signal ERR2 dans l'étape E6 et conduisant par conséquent à la génération du deuxième signal de commande VAL2 dans l'étape E7.

Ledit deuxième signal de commande VAL2 est ensuite délivré à l'oscillateur DCO afin de l'asservir en fréquence dans l'étape E8.

Par ailleurs, l'invention n'est pas limitée à ces modes de mise en œuvre et de réalisation mais en embrasse toutes les variantes.

Par exemple, il est possible de réaliser ladite opération de type modulo en modifiant la profondeur du compteur-diviseur cnt et de l'accumulateur ACC.

## Revendications

1. Procédé de communication sans contact entre un objet (TG) et un lecteur (RD) utilisant une modulation active de charge, le procédé comprenant une synchronisation entre un premier signal de porteuse (CLK) émis par le lecteur (RD) et ayant une fréquence de référence, et un deuxième signal de porteuse (OUT) tiré du signal de sortie (SIG4) d'un oscillateur commandé (DCO) d'une boucle à verrouillage de phase numérique (DPLL) dudit objet (TG), ladite synchronisation comprenant :
- tant qu'un verrouillage de ladite boucle (DPLL) n'a pas été détecté, un asservissement de la fréquence du signal de sortie de l'oscillateur (DCO), sur une fréquence multiple de la fréquence de référence, en commandant l'oscillateur (DCO) avec un premier signal de commande (VAL1) généré à partir d'une première valeur (ERR1) représentative de l'erreur de phase de ladite boucle à verrouillage de phase (DPLL), et
- une fois ledit verrouillage détecté, une poursuite de l'asservissement en commandant l'oscillateur (DCO) avec un deuxième signal de commande (VAL2) généré à partir d'une deuxième valeur (ERR2) obtenue par une opération du type modulo effectuée sur ladite première valeur (ERR1) représentative de l'erreur de phase de la boucle (DPLL).

2. Procédé selon la revendication 1, dans lequel ladite première valeur (ERR1) est un mot numérique comprenant une première séquence de bits (SQ1), et dans lequel ladite opération du type modulo comprend une sélection de bits de poids faible (PF) représentant une deuxième séquence (SQ2) de bits représentative de ladite deuxième valeur (ERR2).

3. Procédé selon la revendication 1 ou 2, comprenant préalablement à l'asservissement par ladite boucle (DPLL), un masquage et/ou une multiplication de la fréquence du premier signal de porteuse (CLK) par un masque et/ou un facteur multiplicatif.

4. Procédé selon la revendication 3, dans lequel le masque ou le facteur multiplicatif est paramétrable.

5. Objet (TG) capable de communiquer sans contact avec un lecteur (RD) par une modulation active de charge, comportant une entrée (2000) pour recevoir un premier signal de porteuse (CLK) émis par le lecteur (RD), une sortie (24) pour délivrer un deuxième signal de porteuse (OUT) tiré d'un signal de sortie (SIG4) d'un oscillateur commandé (DCO) d'une boucle à verrouillage de phase numérique (DPLL), et des moyens de synchronisation (MSYNC) configurés pour synchroniser ledit premier signal de porteuse (CLK) et le deuxième signal de porteuse (OUT), lesdits moyens de synchronisation (MSYNC) comprenant :
- des moyens de détection (MD) configurés pour détecter le verrouillage de ladite boucle (DPLL) ;
- des moyens de commande (MC) configurés pour, tant que les moyens de détection (MD) n'ont pas détecté le verrouillage de ladite boucle (DPLL), asservir la fréquence du signal de sortie de l'oscillateur (DCO) sur une fréquence multiple de la fréquence de référence, en commandant l'oscillateur (DCO) avec un premier signal de commande (VAL1) généré à partir d'une première valeur (ERR1) représentative de l'erreur de phase de ladite boucle à verrouillage de phase (DPLL), et
une fois que les moyens de détection (MD) ont détecté ledit verrouillage, poursuivre l'asservissement en commandant l'oscillateur (DCO) avec un deuxième signal de commande (VAL2) généré à partir d'une deuxième valeur (ERR2) délivrée par un premier module (MD1) configuré pour effectuer une opération du type modulo sur ladite première valeur (ERR1) représentative de l'erreur de phase de la boucle.

6. Objet (TG) selon la revendication 5, dans lequel ladite première valeur (ERR1) est un mot numérique comprenant une première séquence de bits (SQ1), et dans lequel ledit premier module (MD1) est configuré pour effectuer ladite opération en sélectionnant des bits de poids faible (PF) représentant une deuxième séquence de bits (SQ2) représentative de ladite deuxième valeur (ERR2).

7. Objet (TG) selon la revendication 5 ou 6, dans lequel les moyens de synchronisation (MSYNC) comprennent un deuxième module (MD2) configuré pour masquer la fréquence du premier signal de porteuse (CLK) par un masque préalablement à l'asservissement par ladite boucle, et un troisième module (MF) configuré pour multiplier la fréquence du premier signal de porteuse (CLK) par un facteur multiplicatif préalablement à l'asservissement par ladite boucle.

8. Objet (TG) selon la revendication 7, dans lequel le masque ou le facteur multiplicatif est ajustable.

9. Objet (TG) selon l'une des revendications 5 à 8, dans lequel la boucle à verrouillage de phase (DPLL) comprend un filtre de type proportionnel intégral (DF) configuré pour filtrer ladite première valeur (ERR1) représentative de l'erreur de phase et ladite deuxième valeur (ERR2) représentative de l'erreur de phase.

10. Objet (TG) selon l'une des revendications 5 à 9, formant un téléphone émulé en mode carte.

## Patentansprüche

1. Verfahren für die kontaktlose Kommunikation zwischen einem Objekt (TG) und einem Lesegerät (RD), die eine aktive Ladungsmodulation nutzen, wobei das Verfahren eine Synchronisierung zwischen einem ersten Trägersignal (CLK), das von dem Lesegerät (RD) gesendet wird und eine Referenzfrequenz hat, und einem zweiten Trägersignal (OUT) umfasst, das aus dem Ausgangssignal (SIG4) eines von einer digitalen Phasenschleife (DPLL) des Objekts (TG) gesteuerten Oszillators (DCO) abgeleitet wird, wobei die Synchronisierung umfasst:
- solange keine Verriegelung der Schleife (DPLL) ermittelt wird, eine Regelung der Frequenz des Ausgangssignals des Oszillators (DCO) auf eine Mehrfachfrequenz der Referenzfrequenz durch Steuern des Oszillators (DCO) mit einem ersten Steuersignal (VAL1), das auf der Basis eines ersten Werts (ERR1) erzeugt wird, der für den Phasenfehler der Phasenschleife (DPLL) repräsentativ ist, und
- sobald die Verriegelung ermittelt wird, eine Fortsetzung der Regelung durch Steuern des Oszillators (DCO) mit einem zweiten Steuersignal (VAL2), das auf der Basis eines zweiten Werts (ERR2) erzeugt wird, der durch eine Operation vom Typ Modulo erhalten wird, die für den ersten Wert (ERR1) vorgenommen wird, der für den Phasenfehler der Schleife (DPLL) repräsentativ ist.

2. Verfahren nach Anspruch 1, wobei der erste Wert (ERR1) ein digitales Wort ist, umfassend eine erste Bitsequenz (SQ1), und wobei die Operation vom Typ Modulo eine Auswahl niederwertiger Bits (PF) umfasst, die eine zweite Bitsequenz (SQ2) darstellen, die für den zweiten Wert (ERR2) repräsentativ ist.

3. Verfahren nach Anspruch 1 oder 2, das vor der Regelung durch die Schleife (DPLL) eine Maskierung und/oder eine Multiplikation der Frequenz des ersten Trägersignals (CLK) durch eine Maske und/oder einen Multiplikationsfaktor umfasst.

4. Verfahren nach Anspruch 3, wobei die Maske oder der Multiplikationsfaktor parametrierbar ist.

5. Objekt (TG), das imstande ist, durch eine aktive Ladungsmodulation kontaktlos mit einem Lesegerät (RD) zu kommunizieren, aufweisend einen Eingang (2000), um ein erstes, von dem Lesegerät (RD) gesendetes Trägersignals (CLK) zu erhalten, einen Ausgang (24), um ein zweites, aus einem Ausgangssignal (SIG4) eines von einer digitalen Phasenschleife (DPLL) gesteuerten Oszillators (DCO) abgeleitetes Trägersignal (OUT) bereitzustellen, und Synchronisierungsmittel (MSYNC), die ausgelegt sind, um das erste Trägersignal (CLK) und das zweite Trägersignal (OUT) zu synchronisieren, wobei die Synchronisierungsmittel (MSYNC) umfassen:
- Detektionsmittel (MD), die ausgelegt sind, um die Verriegelung der Schleife (DPLL) zu ermitteln;
- Steuermittel (MC), die ausgelegt sind, um, solange die Detektionsmittel (MD) keine Verriegelung der Schleife (DPLL) ermittelt haben, die Frequenz des Ausgangssignals des Oszillators (DCO) auf eine Mehrfachfrequenz der Referenzfrequenz durch Steuern des Oszillators (DCO) mit einem ersten Steuersignal (VAL1) zu regeln, das auf der Basis eines ersten Werts (ERR1), der für den Phasenfehler der Phasenschleife (DPLL) repräsentativ ist, erzeugt wird, und
sobald die Detektionsmittel (MD) die Verriegelung ermittelt haben, die Regelung durch Steuern des Oszillators (DCO) mit einem zweiten Steuersignal (VAL2) fortgesetzt wird, das auf der Basis eines zweiten Werts (ERR2) erzeugt wird, der von einem ersten Modul (MD1) bereitgestellt wird, das ausgelegt ist, um eine Operation vom Typ Modulo für den ersten Wert (ERR1) durchzuführen, der für den Phasenfehler der Schleife repräsentativ ist.

6. Objekt (TG) nach Anspruch 5, wobei der erste Wert (ERR1) ein digitales Wort ist, umfassend eine erste Bitsequenz (SQ1), und wobei das erste Modul (MD1) ausgelegt ist, um die Operation durch Auswahl der niederwertigen Bits (PF) durchzuführen, die eine zweite Bitsequenz (SQ2) darstellen, die für den zweiten Wert (ERR2) repräsentativ ist.

7. Objekt (TG) nach Anspruch 5 oder 6, wobei die Synchronisierungsmittel (MSYNC) ein zweites Modul (MD2) umfassen, das ausgelegt ist, um die Frequenz des ersten Trägersignals (CLK) vor der Regelung durch die Schleife durch eine Maske zu maskieren, und ein drittes Modul (MF), das ausgelegt ist, um die Frequenz des ersten Trägersignals (CLK) vor der Regelung durch die Schleife mit einem Multiplikationsfaktor zu multiplizieren.

8. Objekt (TG) nach Anspruch 7, wobei die Maske oder der Multiplikationsfaktor einstellbar ist.

9. Objekt (TG) nach einem der Ansprüche 5 bis 8, wobei die Phasenschleife (DPLL) einen Filter vom Typ proportional integral (DF) umfasst, der ausgelegt ist, um den ersten Wert (ERR1) zu filtern, der für den Phasenfehler repräsentativ ist, und den zweiten Wert (ERR2), der für den Phasenfehler repräsentativ ist.

10. Objekt (TG) nach einem der Ansprüche 5 bis 9, das ein im Kartenmodus emuliertes Telefon bildet.

## Claims

1. A method of contactless communication between an object (TG) and a reader (RD) using active load modulation, the method comprising synchronising a first carrier signal (CLK) emitted by the reader (RD) and having a reference frequency, and a second carrier signal (OUT) extracted from the output signal (SIG4) of a controlled oscillator (DCO) of a digital phase-locked loop (DPLL) of said object (TG), said synchronisation comprising:
- as long as a locking of said loop (DPLL) has not been detected, locking the frequency of the output signal of the oscillator (DCO) onto a frequency that is a multiple of the reference frequency, by controlling the oscillator (DCO) with a first control signal (VAL1) generated from a first value (ERR1) representative of the phase error of said phase-locked loop (DPLL), and
- once said locking has been detected, continuing the locking by controlling the oscillator (DCO) with a second control signal (VAL2) generated from a second value (ERR2) obtained by a modulo-type operation performed on said first value (ERR1) representative of the phase error of the loop (DPLL).

2. The method according to claim 1, wherein said first value (ERR1) is a digital word comprising a first sequence of bits (SQ1), and wherein said modulo-type operation comprises a selection of least significant bits (PF) representing a second sequence (SQ2) of bits representative of said second value (ERR2).

3. The method according to claim 1 or 2, comprising, prior to the locking by said loop (DPLL), masking and/or multiplying the frequency of the first carrier signal (CLK) by a mask and/or a multiplication factor.

4. The Method according to claim 3, wherein the mask or the multiplication factor is configurable.

5. An object (TG) capable of contactless communication with a reader (RD) by active load modulation, including an input (2000) for receiving a first carrier signal (CLK) emitted by the reader (RD), an output (24) for outputting a second carrier signal (OUT) extracted from an output signal (SIG4) of a controlled oscillator (DCO) of a digital phase-locked loop (DPLL), and synchronising means (MSYNC) configured to synchronise said first carrier signal (CLK) and the second carrier signal (OUT), said synchronising means (MSYNC) comprising:
- detection means (MD) configured to detect the locking of said loop (DPLL);
- control means (MC) configured to, as long as the detection means (MD) have not detected the locking of said loop (DPLL), lock the frequency of the output signal of the oscillator (DCO) onto a frequency that is a multiple of the reference frequency, by controlling the oscillator (DCO) with a first control signal (VAL1) generated from a first value (ERR1) representative of the phase error of said phase-locked loop (DPLL), and
once the detection means (MD) have detected said locking, continue the locking by controlling the oscillator (DCO) with a second control signal (VAL2) generated from a second value (ERR2) output by a first module (MD1) configured to perform a modulo-type operation on said first value (ERR1) representative of the phase error of the loop.

6. The object (TG) according to claim 5, wherein said first value (ERR1) is a digital word comprising a first sequence of bits (SQ1), and wherein said first module (MD1) is configured to perform said operation by selecting least significant bits (PF) representing a second sequence of bits (SQ2) representative of said second value (ERR2).

7. The object (TG) according to claim 5 or 6, wherein the synchronising means (MSYNC) comprise a second module (MD2) configured to mask the frequency of the first carrier signal (CLK) with a mask prior to the locking by said loop, and a third module (MF) configured to multiply the frequency of the first carrier signal (CLK) by a multiplication factor prior to the locking by said loop.

8. The object (TG) according to claim 7, wherein the mask or the multiplication factor is adjustable.

9. The object (TG) according to one of claims 5 to 8, wherein the phase-locked loop (DPLL) comprises a proportional-integral type filter (DF) configured to filter said first value (ERR1) representative of the phase error and said second value (ERR2) representative of the phase error.

10. The object (TG) according to one of claims 5 to 9, forming a card emulated phone.
